# EUROPÄISCHE PATENTSCHRIFT

(11) **EP 0 618 762 B1**
(45) Veröffentlichungstag und Bekanntmachung des Hinweises auf die Patenterteilung: **06.12.1995**
(21) Anmeldenummer: 94200289.0
(22) Anmeldetag: 03.02.1994
(51) Int. Cl.: H05K 7/20

(54) **Schaltungsanordnung**
Circuit arrangement
Montage de circuit

(30) Priorität: 31.03.1993 DE 4310446
(43) Veröffentlichungstag der Anmeldung: 05.10.1994
(73) Patentinhaber: EXPORT-CONTOR Aussenhandelsgesellschaft mbH, D-90253 Nürnberg (DE)
(72) Erfinder:

(56) Entgegenhaltungen:
- EP-A- 0 136 454
- EP-A- 0 443 378
- IBM TECHNICAL DISCLOSURE BULLETIN, Bd.27, Nr.4B, September 1984 Seite 2642 KERJILIAN ET AL. 'HIGH DENSITY MEMORY PACKAGE.'

## Beschreibung

Die Erfindung betrifft eine Schaltungsanordnung nach den Merkmalen des Oberbegriffs des Anspruches 1. Derartige Schaltungsanordnungen sind mehrfach in der Literatur beschrieben.
In DE 41 11 247 C2 wird eine Schaltungsanordnung vornehmlich für Leistungshalbleiteranwendungen dargestellt. Dabei ist die beschriebene Anordnung auf einer Kühleinrichtung räumlich sehr ausgedehnt und deshalb kostenmäßig, thermisch und elektrisch nicht optimal.

Diese Schaltungsanordnungen haben einen großen Flächenbedarf der Kühl- und Montagebauteile. Bei solchen Schaltungsanordnungen mit beispielsweise Leistungs-Halbleiter-Bauelementen bestimmen somit diese Bauteile den Platzbedarf der Anordnung. Durch eine Zweiebenenanordnung kann der Raumbedarf etwa halbiert werden.

Aus US 5,157,588 ist weiterhin eine Schaltungsanordnung bekannt, bei der Trägerplatten mit Kühlbauteilen spiegelbildlich übereinander angeordnet sind.

In FR 2 614 494 A1 wird eine Schaltungsanordnung beschrieben, bei der die Leiterplatten mittels Federn elektrisch verbunden werden.

Dieser Erfindung liegt die Aufgabe zugrunde, einen zerlegbaren, stofflich trennbaren, thermisch und räumlich optimalen Aufbau einer Schaltungsanordnung zu beschreiben, der ohne Begrenzung der Leistung zuverlässig wirkt.

Diese Aufgabe wird bei einer Schaltungsanordnung der eingangs genannten Art durch die Merkmale des kennzeichnenden Teiles des Anspruches 1 gelöst. Vorteilhafte Weiterbildungen der erfindungsgemäßen Schaltungsanordnung sind in den Unteransprüchen gekennzeichnet.

Bei der Lösung der Aufgabe wird in der Anordnung der DE 41 11 247 C2 das Montageelement durch mindestens eine spiegelbildliche weitere Anordnung ersetzt, so daß diese Anordnung die mechanische Aufgabe des Montageelementes übernimmt. Die elektrischen Verbindungen an allen erforderlichen und schaltungstechnisch möglichen Stellen werden mittels Federelementen und/oder Leiterplatten hergestellt. Beispielsweise werden die Verbindungselemente zu den äußeren Anschlüssen hier flächig ausgebildet (z.B. als Leiterplatte oder Strombänder) und mit der Trägerplatte durch Druck kontaktiert. Die Anordnung wird durch mechanische Spannelemente (z.B. Schraubbolzen) durch Druck lösbar verbunden und fixiert, so daß eine Schaltungsanordnung mit hoher räumlicher Dichte entsteht und durch die Druckkontaktierung eine hohe Zuverlässigkeit gegen Wechsellastbeanspruchung auch bei großer Leistung erreichbar ist.

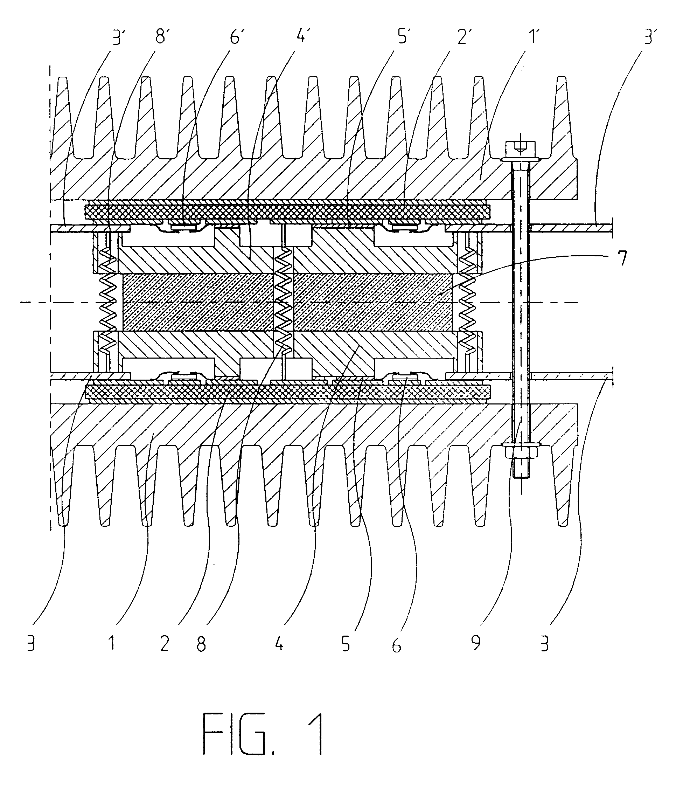

Die Erfindung wird anhand einer nicht maßstabsgerechten Figur 1 mit Kennzeichnung der erfindungsrelevanten Bauteile nachfolgend näher erläutert.

Auf einem Kühlkörper (1,1′) wird eine Trägerplatte (2,2′) aufgelegt.Zur besseren Wärmeübertragung wurde die Trägerplatte oder der Kühlkörper vordem mit einer Wärmeleitpaste versehen. Die Trägerplatten können beispielhaft mit Kupfer beidseitig gebondete Keramiken sein, die in Lötprozessen mit allen erforderlichen Bauelementen z.B. Leistungs-Halbleiter-Bauelementen (6,6′) auf Leiterbahnen versehen worden sind. Die internen Verbindungen auf der Trägerplatte werden beispielhaft durch Drahtbonden hergestellt.

Auf diese Trägerplatte wird ein Verbindungsträger, beispielsweise eine Leiterplatte (3,3′) angebracht und justiert. Der Verbindungsträger an sich ist in seiner Formgebung mit Ausbrüchen, Durchbrüchen und solchen Konturen versehen, daß eine paßgerechte Lage zur Trägerplatte gegeben ist. Dabei kann die beispielsweise Leiterplatte ein- oder mehrlagig mit Leiterbahnen kaschiert sein und auch an vorgegebenen Stellen flexible Leiterbahnen in Form von flexiblen Leiterplatten, Stanzteile aus elektrisch leitendem Metall oder Litzen aufweisen. Weiterhin ist es möglich, Leiterplatten mit direkten oder indirekten Steckverbindern für die äußere Kontaktierung oder Verschaltung an den außen liegenden Leiterplattenenden vorzusehen.

Durch an sich bekannte Brückenelemente (4;4′) mit Hohlräumen und Stegen, auch mit Metallisierungen (5,5′) zur elektrischen Kontaktierung einzelner Schaltungsteile, wird die Druckkontaktierung der gesamten Schaltungsanordnung ermöglicht. Die Brückenelemente (4,4′) sind in Form und Kontur dem konkreten Schaltungsaufbau so angepaßt, daß bei Beauflagung mit Druck ein guter ohmscher Kontakt zu allen schaltungstechnisch erforderlichen Kontaktstellen hergestellt wird und ein guter Wärmetransport der in Betrieb entstehenden Verlustwärme zu den Kühlbauteilen (1,1′) gegeben ist.

Auf das Brückenelement kann ein an sich bekanntes Kissenelement zum Druckausgleich positioniert werden. Dieses Kissenelement (7) ist in der Form und seiner Druckbelastbarkeit den mechanischen Aufbauerfordernissen angepaßt und dimensioniert.

In entsprechende Durchführungen des Kissenelementes (7) und der Brückenelemente (4,4′) werden Federn (8,8′) zur elektrischen Kontaktierung zwischen der oberen und unteren Baugruppe eingebracht. Diese Durchführungen sind gleichzeitig zur genauen Positionierung der Kontaktfedern auf die Kontaktinseln der Halbleiterbauelemente, Trägerplatten oder Leiterplatten ausgerichtet.

Durch paßgenaue Auflage einer zweiten Baueinheit in durch den Aufbau bestimmten Reihenfolge, bestehend aus Brückenelement (4′), Trägerplatte (2′) mit oder ohne Verbindungsträger (3′) und Kühlbauelement (1′) ist die gesamte Schaltungsanordnung für die Druckkontaktierung vorbereitet. Der obere Aufbau kann der Schaltung entsprechend ein genaues Abbild des unteren Aufbaues sein, kann jedoch auch eine andere Struktur und andere Bauelemente in sich tragen. Entscheidend ist hier lediglich der mechanisch übereinstimmende Aufbau bezüglich der Konturen und Durchführungen seiner Einzelbauteile.

Schließlich wird mittels Spannelemente (9) die gesamte Schaltung gleichmäßig druckkontaktiert. Die an sich bekannten Spannelemente können beispielsweise Schraubbolzen sein, die in entsprechende Durchführungen der Kühlelemente passen und mittels Druckfedern (nicht gezeichnet) auf einen vorgegebenen Einstelldruck festgezogen werden.

Durch die entsprechende Wahl der gegenseitigen Geometrien der Aufbauelemente wird die gesamte Schaltungsanordnung durch die Spannelemente (9) zueinander justiert und fixiert.

## Patentansprüche

1. Schaltungsanordnung mit mindestens zwei Trägerplatten (2,2′), auf welchen mindestens je ein zu kühlendes chipförmiges Bauelement (6,6′), insbesondere Halbleiterbauelement und Kontaktflächen vorhanden sind, wobei jedes Bauelement mit zugehörigen Kontaktflächen mittels Verbindungselementen elektrisch leitend verbunden ist, mit Kühlbauteilen (1,1′), auf welchen die Trägerplatten (2,2′) angeordnet sind, und zugehörigen Brückenelementen (4,4′)
**dadurch gekennzeichnet, daß**
mindestens zwei Kühlbauteile (1 und 1′) mit Trägerplatten (2,2′) und Brückenelementen (4,4′) spiegelbildlich und übereinander angeordnet sind und mittels mechanischer Spannelemente (9) lösbar miteinander verbunden sind, wobei elektrisch erforderliche Verbindungen zu den Trägerplatten (2,2′) über Federn (8,8′) und/oder Leiterplatten (3,3′) hergestellt werden und die gesamte Schaltungsanordnung zerstörungsfrei zerlegbar ist, wenn Aufbauelemente ausgewechselt werden sollen.

2. Schaltungsanordnung nach Anspruch 1, dadurch gekennzeichnet, daß zwischen den Brückenelementen (4 und 4′) mindestens ein Kissenelement (7) als Druckspeicher formgerecht eingesetzt wird.

3. Schaltungsanordnung nach Anspruch 1, dadurch gekennzeichnet, daß das mindestens eine untere und das mindestens eine obere Kühlbauteil (1,1′) Durchführungen für mechanische Spannelemente (9) zur paßgenauen Justage und Druckkontaktierung aufweisen.

4. Schaltungsanordnung nach Anspruch 1, dadurch gekennzeichnet, daß die mechanischen Spannelemente (9) Schraubbolzen sind.

5. Schaltungsanordnung nach Anspruch 1, dadurch gekennzeichnet, daß Verbindungselemente (3,3′) für die Kontaktierung der Trägerplatte (2,2′) als Leiterplatten ausgebildet sind und über die mechanischen Spannelemente (9) fixiert und kontaktiert werden.

6. Schaltungsanordnung nach Anspruch 1 oder 2, dadurch gekennzeichnet, daß Federn (8,8′) als Verbindungselemente für die elektrische Kontaktierung von Kontaktstellen der unteren (2) mit der oberen (2′) Trägerplatte und/oder Leiterplatte (3 oder 3′) eingesetzt sind und zu deren Justage Durchführungen in den Brückenelementen (4,4′) und/oder Kissenelementen (7) vorgesehen sind.

7. Schaltungsanordnung nach Anspruch 1, dadurch gekennzeichnet, daß mindestens ein Brückenelement (4 oder 4′) metallisierte Leiterbahnen(5,5′) zur elektrischen Kontaktierung der Trägerplatte (2,2′) und/oder der Leiterplatte (3,3′) aufweist und diese durch Druck kontaktiert.

## Claims

1. Circuit arrangement comprising at least two carrier plates (2, 2′) upon which respectively at least one chip-shaped component (6, 6′) to be cooled, in particular a semi-conductor component, and contact surfaces, are provided, each component with associated contact surfaces being electrically conductively connected by means of connecting elements, cooling elements (1, 1′) upon which the carrier plates (2, 2′) are arranged, and associated bridging elements (4, 4′),
**characterized in that**
at least two cooling elements (1 and 1′) with carrier plates (2, 2′) and bridging elements (4, 4′) are arranged in mirrored form and above one another and releasably connected with each other by means of mechanical clamping elements, wherein electrically required connections to the carrier plates (2, 2′) are produced by means of springs (8, 8′) and/or printed circuit boards (3, 3′) and the entire circuit arrangement is non-destructively separable when mounting elements are to be exchanged.

2. Circuit arrangement according to claim 1, **characterized in that** at least one cushion element (7) is inserted true to form as a pressure storage between the bridging elements (4 and 4′).

3. Circuit arrangement according to claim 1, **characterized in that** the at least one lower and the at least one upper cooling elements (1, 1′) have openings for mechanical clamping elements (9) for exact-fit adjustment and pressure contact.

4. Circuit arrangement according to claim 1, **characterized in that** the mechanical clamping elements (9) are screw bolts.

5. Circuit arrangement according to claim 1, **characterized in that** connecting elements (3, 3′) for contacting the carrier plates (2, 2′) are formed as printed circuit boards and secured and contacted by means of the mechanical clamping elements (9).

6. Circuit arrangement according to claim 1 or 2, **characterized in that** springs (8, 8′) are used as connecting elements for the electrical contacting of contact points of the lower carrier plate (2) with the upper carrier plate (2′) and/or printed circuit board (3 or 3′) and, for their adjustment, openings are provided in the bridging elements (4, 4′) and/or cushion elements (7).

7. Circuit arrangement according to claim 1, **characterized in that** at least one bridging element (4 or 4′) has metallized conductor strips (5, 5′) for electrically contacting the carrier plate (2, 2′) and/or the printed circuit board (3, 3′) and contacts these by means of pressure.

## Revendications

1. Disposition de circuit avec au moins deux plaques-supports (2,2′) sur lesquelles on a au moins un composant (6,6′) en forme de puce à refroidir, notamment un composant à semi-conducteurs et des surfaces de contact, chaque composant étant relié de façon électroconductrice à des surfaces de contact spécifiques au moyen d'éléments de liaison, avec des composants de réfrigération (1,1′) sur lesquels sont disposées les plaques-supports (2,2′), et des éléments de pont spécifiques (4,4′)
caractérisée en ce qu'au moins deux composants de réfrigération (1 et 1′) avec des plaques-supports (2,2′) et des éléments de pont (4,4′) sont disposés de façon symétrique et superposée et sont reliés entre eux de façon amovible au moyen d'éléments de serrage (9) mécaniques, des liaisons nécessaires au plan électrique avec les plaques supports (2,2′) étant établies au moyen de ressorts (8,8′) et/ou des cartes imprimées (3,3′) et l'ensemble de la disposition de circuit étant démontable sans destruction lorsqu'on doit remplacer des éléments de la structure.

2. Disposition de circuit selon la revendication 1, caractérisée en ce qu'au moins un élément de coussin (7) avec une forme adaptée est inséré comme accumulateur de pression entre les éléments de pont (4 et 4′).

3. Disposition de circuit selon la revendication 1, caractérisée en ce qu'au moins un composant de réfrigération inférieur et au moins un composant de réfrigération (1,1′) supérieur présentent des passages pour des éléments de serrage (9) mécaniques pour un ajustage précis et un contactage par pression.

4. Disposition de circuit selon la revendication 1, caractérisée en ce que les éléments de serrage (9) mécaniques sont des boulons filetés.

5. Disposition de montage selon la revendication 1, caractérisée en ce que des éléments de liaison (3,3′) pour le contactage de la plaque-support (2,2′) sont conçus comme des cartes imprimées et sont fixés et contactés par les éléments de serrage (9) mécaniques.

6. Disposition de circuit selon la revendication 1 ou 2, caractérisée en ce que des ressorts (8,8′) sont insérés comme éléments de liaison pour le contactage électrique de points de contact de la plaque-support inférieure (2) avec la plaque support supérieure (2′) et/ou la carte imprimée (3 ou 3′) et, pour leur ajustage, des passages sont prévus dans les éléments de pont (4,4′) et/ou des éléments de coussin (7).

7. Disposition de circuit selon la revendication 1, caractérisée en ce qu'au moins un élément de pont (4 ou 4′) présente des pistes conductrices (5,5′) métallisées pour le contactage électrique de la plaque-support (2,2′) et/ou de la plaque support (3,3′) et contacte celles-ci par pression.
